# EUROPEAN PATENT APPLICATION

(11) **EP 2 244 321 A1**
(43) Date of publication of application: **27.10.2010**
(21) Application number: 10250537.7
(22) Date of filing: 22.03.2010
(51) Int. Cl.: H01M 2/34, H01M 10/48, H02J 7/00, G01R 31/36, H01M 6/50, H01M 10/42

(54) **Battery module, battery system, and electric vehicle**

(30) Priority: 24.04.2009 JP 2009106881
(71) Applicant: Sanyo Electric Co., Ltd., Osaka 570-8677 (JP)
(72) Inventor: Ohkura, Kazumi, Moriguchi City, Osaka, 570-8677 (JP); Nishihara, Yoshitomo, Moriguchi City, Osaka, 570-8677 (JP); Taguchi, Kenji, Moriguchi City, Osaka, 570-8677 (JP); Kishimoto, Keiji, Moriguchi City, Osaka, 570-8677 (JP)
(74) Representative: Calderbank, Thomas Roger

(57) **Abstract**

A plurality of battery cells is connected in series via a plurality of bus bars. An FPC board is attached to the bus bars. On the FPC board, PTC elements are respectively arranged in close proximity to the bus bars. Each of conductor lines on the FPC board extends between an attachment portion of the bus bar and the PTC element arranged in close proximity to the bus bar, extends between the PTC element and one end of the FPC board, and is connected to a plurality of connection terminals of a printed circuit board. The connection terminals are electrically connected to a detecting circuit.

## Description

The present invention relates to a battery module, a battery system, and an electric vehicle including the same.

Conventionally in movable objects such as electric automobiles using electric power as driving sources, battery modules including a plurality of battery cells connected in series or in parallel have been used.

In order to recognize the residual capacity (charged capacity) of the battery module or prevent overcharge and overdischarge of the battery module, a terminal voltage of the battery module is to be detected. Therefore, a detecting circuit for detecting the terminal voltage of the battery module is connected to the battery module (see, e.g., JP 8-162171 A).

When the detecting circuit is connected to the battery module, as described above, a short may occur between the detecting circuit and the battery module. Furthermore, a short may occur within the detecting circuit. In the case, a large current flows from the battery module to a short-circuited portion. Therefore, the battery module may deteriorate by generated heat.

The present invention may provide a battery module that is prevented from deteriorating by a short, a battery system, and an electric vehicle including the same.
(1) According to an aspect of the present invention, a battery module includes a battery cell, a voltage detection line connected to the battery cell for detecting a terminal voltage of the battery cell, and a current limiting element inserted in the voltage detection line for limiting, when a current flowing through the voltage detection line is greater than a predetermined value, the current.
   In the battery module, the terminal voltage of the battery cell is detected using the voltage detection line connected to the battery cell.
   When the voltage detection line is short-circuited, the large current flows through the current limiting element inserted in the voltage detection line. In this case, the current limiting element limits the current. Therefore, situations in which the large current flows through the voltage detection line are solved. As a result, the battery module is prevented from deteriorating.
(2) The battery cell may be provided in plural number. The battery module may further include a connecting member for connecting electrodes of the adjacent battery cells to each other. The voltage detection line may be provided in a flexible member attached to the connecting member and may be connected to the connecting member.
   In this case, the voltage detection line is provided in the flexible member attached to the connecting member so that the voltage detection line is sufficiently prevented from being short-circuited.
(3) The flexible member may be a flexible printed circuit board having the voltage detection line as a wiring pattern, and the current limiting element may be attached to the flexible printed circuit board.
   In this case, the voltage detection line is sufficiently prevented from being short-circuited while the voltage detection line and the current limiting element are reliably connected to each other on the flexible printed circuit board.
(4) The flexible printed circuit board may be attached to the connecting member to extend in one direction along the connecting member, and the current limiting element may be arranged in a region corresponding to a range between both ends of the connecting member in the one direction in the flexible printed circuit board.
   In this case, the current limiting element is provided at a position close to the connecting member. In the flexible printed circuit board, the range, between both the ends of the connecting member is more difficult to deflect than a range outside both the ends of the connecting member. This can suppress the effect of the deflection of the flexible printed circuit board on the current limiting element.
   Since the connecting member and the current limiting element are arranged in close proximity to each other, the voltage detection line between the current limiting element and the connecting member can be shortened. Therefore, a short can be prevented from occurring between the current limiting element and the connecting member.
(5) According to another aspect of the present invention, a battery system for supplying electric power to a load includes a battery module, a connection switcher configured to enable connection and disconnection between the battery module and the load, and a controller that controls the connection switcher, in which the battery module further includes a battery cell, a voltage detection line connected to the battery cell for detecting a terminal voltage of the battery cell, and a current limiting element inserted in the voltage detection line for limiting, when a current flowing through the voltage detection line is greater than a predetermined value, the current, and the controller controls the connection switcher based on a voltage detected using the voltage detection line in the battery module.
   In the battery module in the battery system, the terminal voltage of the battery cell is detected using the voltage detection line connected to the battery cell.
   When the voltage detection line is short-circuited, the large current flows through the current limiting element inserted in the voltage detection line. In this case, the current limiting element limits the current. Therefore, situations in which the large current flows through the voltage detection line are solved. As a result, the battery module is prevented from deteriorating.
   The connection switcher is controlled based on the voltage detected using the voltage detection line in the battery module. The connection switcher causes connection between the battery module and the load so that the electric power is supplied to the load from the battery module. The connection switcher causes disconnection between the battery module and the load so that the electric power is not supplied to the load from the battery module.
(6) According to still another aspect of the present invention, an electric vehicle includes a battery module, a motor driven by electric power from the battery module, and a drive wheel that rotates by a torque generated by the motor, in which the battery module further includes a battery cell, a voltage detection line connected to the battery cell for detecting a terminal voltage of the battery cell, and a current limiting element inserted in the voltage detection line for limiting, when a current flowing through the voltage detection line is greater than a predetermined value, the current.

In the electric vehicle, the motor is driven by the electric power from the battery module. The drive wheel rotates by the torque generated by the motor so that the electric vehicle moves.

In the battery module, the terminal voltage of the battery cell is detected using the voltage detection line connected to the battery cell.

When the voltage detection line is short-circuited, the large current flows through the current limiting element inserted in the voltage detection line. In this case, the current limiting element limits the current. Therefore, situations in which the large current flows through the voltage detection line are solved. As a result, the battery module is prevented from deteriorating.

Other features, aspectselements, characteristics, and advantages of the present invention will become more apparent from the following detailed description of embodiments of the present invention when taken in conjunction with the accompanying reference to the attached drawings.

In the drawings:
Fig. 1 is a block diagram illustrating the configuration of a battery system according to a first embodiment;
Fig. 2 is an external perspective view of a battery module;
Fig. 3 is a plan view of a battery module;
Fig. 4 is a side view of a battery module;
Fig. 5 is an external perspective view of a bus bar;
Fig. 6 is an external perspective view illustrating a state where a plurality of bus bars and a plurality of PTC elements are attached to an FPC board;
Fig. 7 is a schematic plan view for explaining connection between bus bars and a detecting circuit;
Fig. 8 is a schematic plan view illustrating another example of a method for fixing an FPC board and bus bars;
Fig. 9 is a schematic plan view and a schematic side view illustrating another example of the arrangement of a PTC element;
Fig. 10 is a schematic plan view and a schematic side view illustrating still another example of the arrangement of a PTC element;
Fig. 11 is a schematic plan view illustrating a modified example of an FPC board;
Fig. 12 is a schematic plan view and a schematic side view illustrating a further modified example of an FPC board;
Fig. 13 is a schematic plan view illustrating a modified example of bus bars; and
Fig. 14 is a block diagram illustrating the configuration of an electric vehicle according to a second embodiment.

### [1] First Embodiment

A battery module according to a first embodiment and a battery system including the same will be described below with reference to the drawings. The battery module and the battery system according to the present embodiment are carried on an electric vehicle (e.g., an electric automobile) using electric power as a driving source.

### (1) Configuration of Battery System

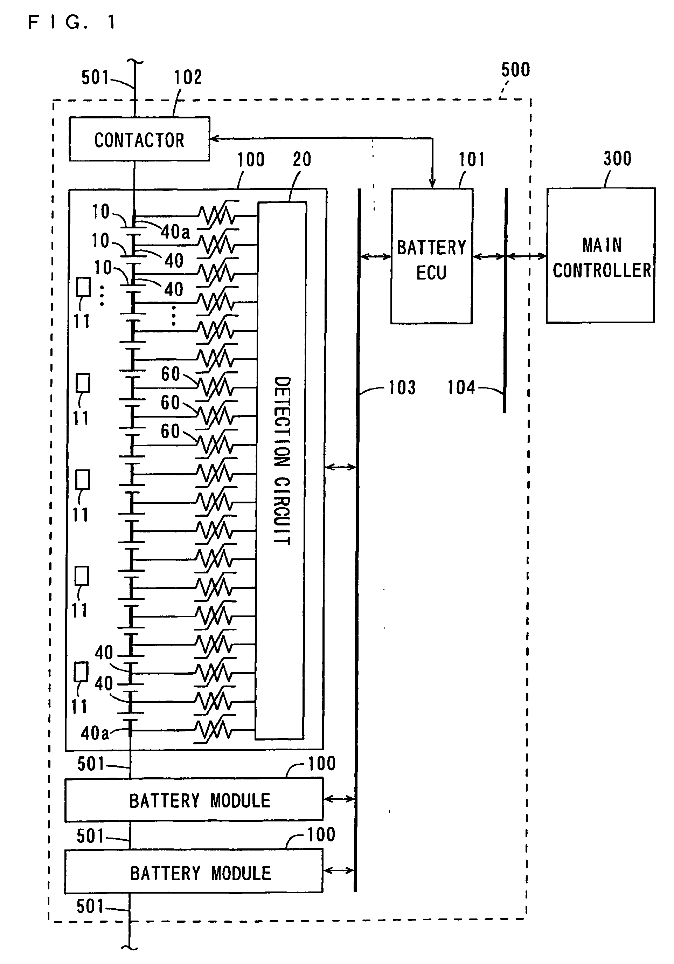

Fig. 1 is a block diagram illustrating the configuration of a battery system according to a first embodiment. As illustrated in Fig. 1, a battery system 500 includes a plurality of battery modules 100, a battery electronic control unit (ECU) 101, and a contactor 102, and is connected to a main controller 300 in an electric vehicle via a bus 104.

The battery modules 100 in the battery system 500 are connected to one another via a power supply line 501. Each of the battery modules 100 includes a plurality of (eighteen in this example) battery cells 10, a plurality of (five in this example)thermistors 11, and a detecting circuit 20.

In each of the battery modules 100, the battery cells 10 are integrally arranged to be adjacent to one another, and are connected in series by a plurality of bus bars 40. Each of the battery cells 10 is a secondary battery such as a lithium ion battery or a nickel hydrogen battery.

The battery cells 10 arranged at both ends of the battery module 100 are connected to the power supply line 501, respectively, via the bus bars 40a. Thus, in the battery system 500, all the battery cells 10 in the plurality of battery modules 100 are connected in series. The power supply line 501 pulled out of the battery system 500 is connected to a load such as a motor in the electric vehicle.

The detecting circuit 20 is electrically connected to each of the bus bars 40, 40a via a positive temperature coefficient (PTC) element 60. The detecting circuit 20 is electrically connected to each of the thermistors 11. The detecting circuit 20 detects a terminal voltage of each of the battery cells 10 and its temperature and a current flowing through each of the bus bars 40, 40a. The details of the battery module 100 will be described below.

The detecting circuit 20 in each of the battery modules 100 is connected to the battery ECU 101 via a bus 103. Thus, the voltage, the current, and the temperature that are detected by the detecting circuit 20 are given to the battery ECU 101.

The battery ECU 101 calculates the charged capacity of each of the battery cells 10 based on the voltage, the current, and the temperature that are given from the detecting circuit 20 in each of the battery modules 100, for example, and carries out charge/discharge control of the battery module 100 based on the charged capacity. The battery ECU 101 detects an abnormality in each of the battery modules 100 based on the voltage, the current, and the temperature that are given from the detecting circuit 20 in the battery module 100. The abnormality in the battery module 100 includes overdischarge, overcharge, and a temperature abnormality of the battery cell 10, for example.

The contactor 102 is inserted in the power supply line 501 connected to the battery module 100 at one end of the battery system 500. The battery ECU 101 turns the contactor 102 off when it detects the abnormality in the battery module 100. Thus, no current flows through each of the battery modules 100 when the abnormality occurs This prevents the battery module 100 from generating abnormal heat.

The battery ECU 101 is connected to the main; controller 300 via the bus 104. The charged capacity of each of the battery modules 100 (the charged capacity of the battery cells 10) is given to the main controller 300 from the battery ECU 101. The main controller 300 controls the power of the electric vehicle (e.g., the rotational speed of the motor in the electric vehicle) based on the charged capacity. When the charged capacity of each of the battery modules 100 is reduced, the main controller 300 controls a power generation device (not illustrated) connected to the power supply line 501, to charge the battery module 100.

### (2) Details of Battery Module

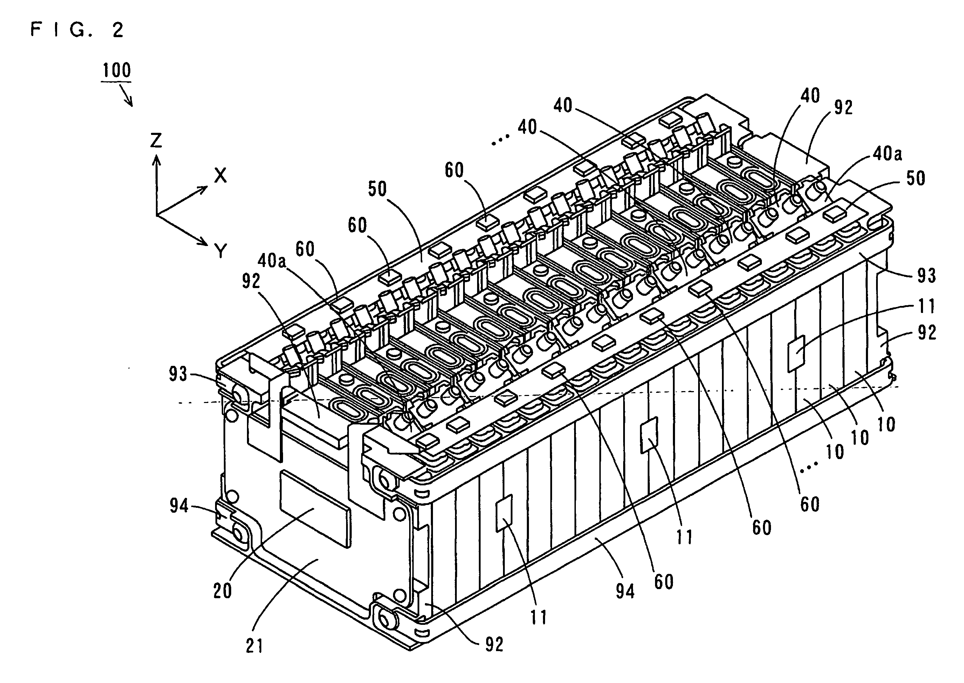

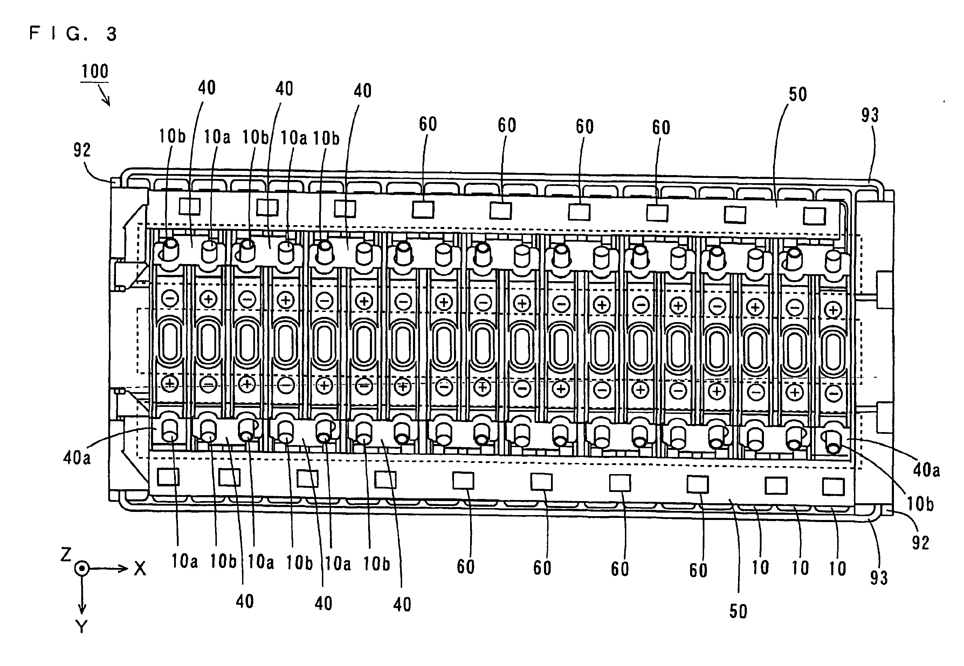

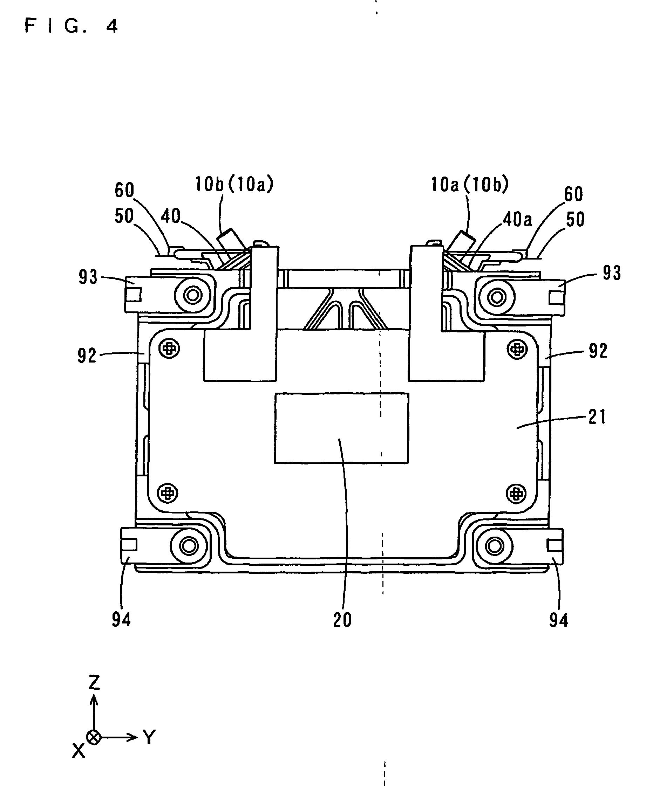

The details of the battery module 100 will be described. Fig. 2 is an external perspective view of the battery module 100, Fig. 3 is a plan view of the battery module 100, and Fig. 4 is a side view of the battery module 100.

In Figs. 2 to 4 and Figs. 6 to 13, described below, three directions that are perpendicular to one another are respectively defined as an X-direction a Y-direction, and a Z-direction, as indicated by arrows X, Y, and Z. In this example, the X-direction and the Y-direction are directions parallel to a horizontal plane, and the Z-direction is a direction perpendicular to the horizontal plane.

As illustrated in Figs. 2 to 4, in the battery module 100, a plurality of battery cells 10 having a flat and substantially rectangular parallelepiped shape is arranged to line up in the X-direction. In this state, the battery cells 10 are integrally fixed by a pair of end surface frames 92, a pair of upper end frames 93, and a pair of lower end frames 94.

The pair of end surface frames 92 has a substantially plate shape, and is arranged parallel to a Y-Z plane. The pair of upper end frames 93 and the pair of lower end frames 94 are arranged to extend in the X-direction.

Connection portions for connecting the pair of upper end frames 93 and the pair of lower end frames 94 are respectively formed at four corners of the pair of end surface frames 92. With the plurality of battery cells 10 arranged between the end surface frames 92, the pair of upper end frames 93 is attached to the connection portions at the upper corners of the pair of end surface frames 92, and the pair of lower end frames 94 is attached to the connection portions s at the lower corners of the pair of end surface frames 92. Thus, the battery cells 10 are integrally fixed to line up in the X-direction.

A rigid printed circuit board (hereinafter abbreviated as a printed circuit board) 21 is attached to an outer surface of one of the end surface frames 92 with a predetermined distance therebetween. The detecting circuit 20 is provided on the printed circuit board 21.

Here, the plurality of battery cells 10 each have a plus electrode 10a arranged on an upper surface portion on one end side or the other end side in the Y-direction, and have a minus electrode 10b arranged on an upper surface portion on the opposite side. Each of the electrodes 10a, 10b is provided to be inclined and project upward (see Fig. 4).

In the following description, the battery cell 10 adjacent to the end surface frame 92 on which the printed circuit board 21 is not attached to the battery cell 10 adjacent to the end surface frame 92 on which the printed circuit board 21 is attached are referred to as first to eighteenth battery cells 10.

As illustrated in Fig. 3, in the battery module 100, the battery cells 10 are arranged so that the respective positional relationships between the plus electrodes 10a and the minus electrodes 10b in the Y-direction in the adjacent battery cells are opposite to each other.

Thus, between the two adjacent battery cells 10 the plus electrode 10a and the minus electrode 10b of one of the battery cells 10 are respectively in close proximity to the minus electrode 10b and the plus electrode 10a of the other battery cell 10. In this state, the bus bar 40 is attached to the two electrodes in close proximity to each other. Thus, the battery cells 10 are connected in series.

More specifically, the common bus bar 40 is attached to the plus electrode 10a of the first battery cell 10 and the minus electrode 10b of the second battery cell 10. The common bus bar 40 is attached to the plus electrode 10a of the second battery cell 10 and the minus electrode 10b of the third battery cell 10. Similarly, the common bus bar 40 is attached to the plus electrode 10a of each of the odd-numbered battery cells 10 and the minus electrode 10b of each of the even-numbered battery cells 10. The common bus bar 40 is attached to the plus electrode 10a of each of the even-numbered battery cells 10 and the minus electrode 10b of each of the odd-numbered battery cells 10.

The bus bars 40a for externally connecting the power supply line 501 are respectively attached to the minus electrode 10b of the first battery cell 10 and the plus electrode 10a of the eighteenth battery cell 10.

A long flexible printed circuit board (hereinafter abbreviated as an FPC board) 50 extending in the X-direction is connected in common to the plurality of bus bars 40 at respective one ends in the Y-direction of the plurality of battery cells 10. Similarly, a long FPC board 50 extending in the X-direction is connected in common to the plurality of bus bars 40, 40a at the respective other ends in the Y-direction of the plurality of battery cells 10.

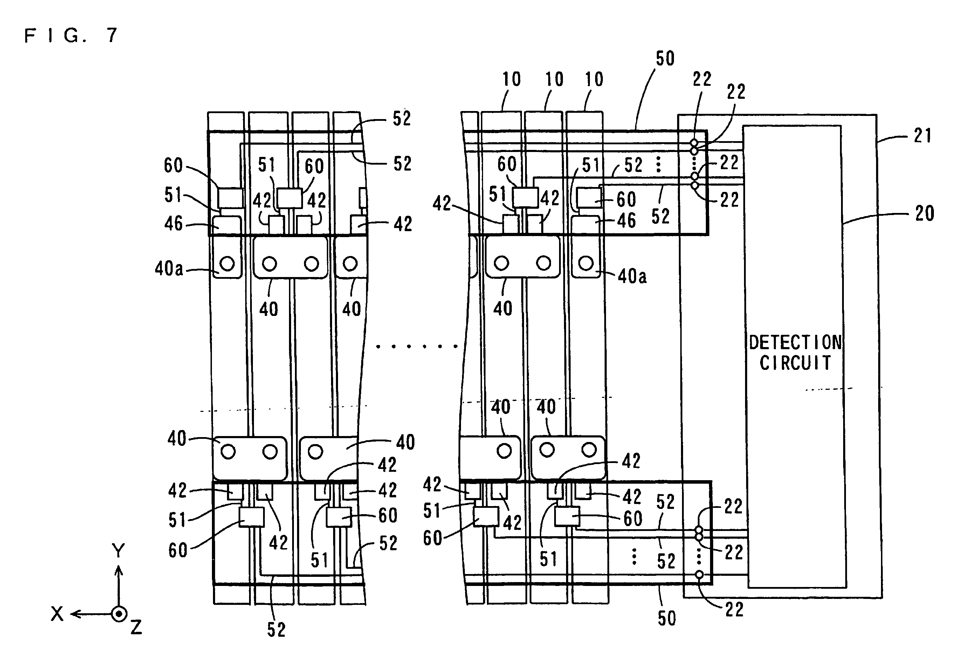

The FPC board 50 mainly has a configuration in which a plurality of conductor lines (wiring patterns) 51, 52 (see Fig. 7, described below) is formed on an insulating layer, and has bending characteristics and flexibility. Polyimide, for example, is used as a material for the insulating layer composing the FPC board 50, and copper, for example, is used as a material for the conductor lines 51, 52. On the FPC board 50, the PTC elements 60 are respectively arranged in close proximity to the bus bars 40, 40a.

Each of the FPC boards 50 is folded at right angles inward and further folded downward at an upper end portion of the end surface frame 92 (the end surface frame 92 on which the printed circuit board 21 is attached), and is connected to the printed circuit board 21.

### (3) Structures of Bus Bar and FPC Board

The details of the structures of the bus bars 40, 40a and the FPC board 50 will be then described. The bus bar 40 for connecting the plus electrode 10a and the minus electrode 10b of the adjacent battery cells 10 is hereinafter referred to as a bus bar 40 for two electrodes, and the bus bar 40a for connecting the plus electrode 10a or the minus electrode 10b of the one battery cell 10 and the power supply line 501 is referred to as a bus bar 40a for a single electrode.

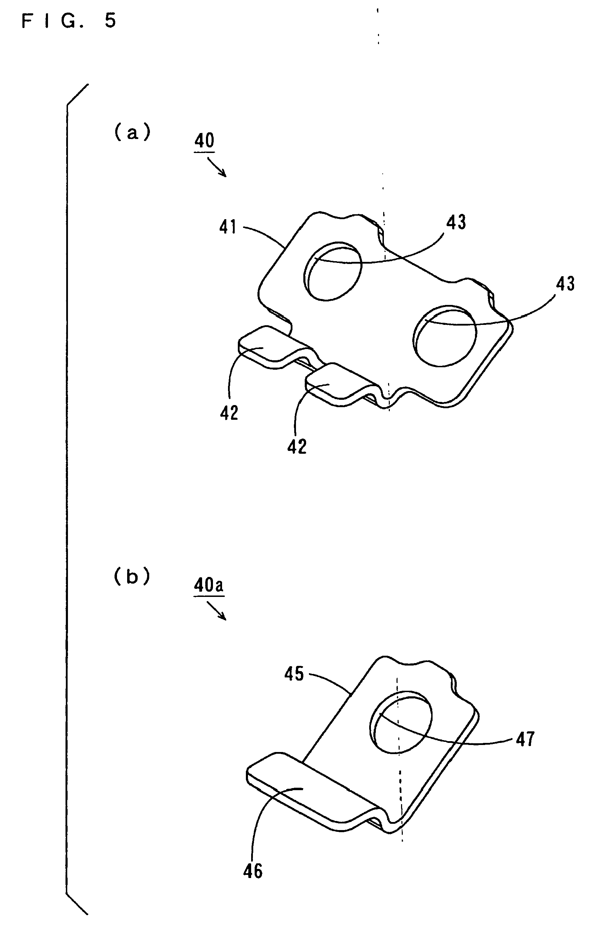

Fig. 5 (a) is an external perspective view of the bus bar 40 for two electrodes, and Fig. 5 (b) is an external perspective view of the bus bar 40a for a single electrode.

As illustrated in Fig. 5 (a), the bus bar 40 for two electrodes includes a base portion 41 having a substantially rectangular shape, and a pair of attachment portions 42 bent and extending toward one surface side from one side of the base portion 41. A pair of electrode connection holes 43 is formed in the base portion 41.

As illustrated in Fig. 5 (b), the bus bar 40a for a single electrode includes a base portion 45 having a substantially square shape, and a attachment portion 46 bent and extending toward one surface side from one side of the base portion 45. An electrode connection hole 47 is formed in the base portion 45.

In the present embodiment, the bus bars 40, 40a have a configuration in which a surface of tough pitch copper is nickel-plated, for example.

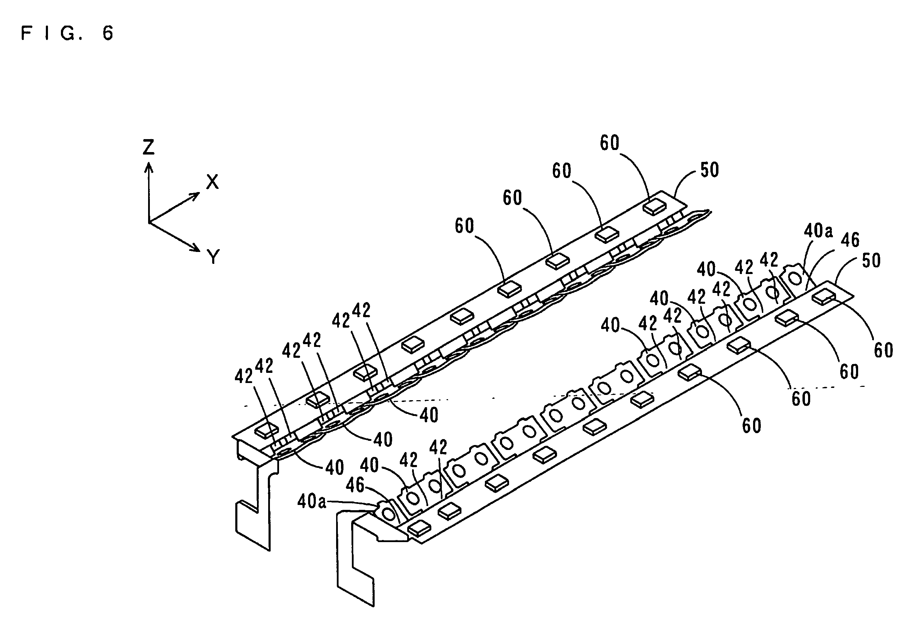

Fig. 6 is an external perspective view illustrating a state where the plurality of bus bars 40, 40a and the plurality of PTC elements 60 are attached to the FPC board 50. As illustrated in Fig. 6, the attachment portions 42, 46 in the bus bars 40,40a are respectively attached to the two FPC boards 50 at a predetermined distance in the X-direction. , The PTC elements 60 are attached to each of the two FPC boards 50 at the same distance as the distance between the bus bars 40, 40a.

When the battery module 100 is manufactured, the two FPC boards 50 respectively having the plurality of bus bars 40, 40a and the plurality of PTC elements 60 attached thereon are attached to the battery cells 10 integrally fixed by the end surface frames 92 (Fig. 2), the upper end frames 93 (Fig. 2), and the lower end frames 94 (Fig. 2).

During the attachment, the plus electrode 10a and the minus electrode 10b of the adjacent battery cells 10 are respectively fitted in the electrode connection holes 43, 47 formed in each of the bus bars 40, 40a. Male screws are respectively formed in the plus electrode 10a and the minus electrode 10b. Nuts (not illustrated) are respectively screwed into the male screws with the plus or minus electrodes 10a, 10b in the battery cells 10 fitted in the bus bars 40, 40a.

In this way, the plurality of bus bars 40, 40a is attached to the plurality of battery cells 10 while the FPC boards 50 are held in a substantially horizontal posture by the plurality of bus bars 40, 40a.

### (4) Connection between Bus Bar and Detection Unit

Connection between the bus bars 40, 40a and the detecting circuit 20 will be then described. Fig. 7 is a schematic plan view for explaining the connection between the bus bars 40, 40a and the detecting circuit 20.

As illustrated in Fig. 7, the FPC board 50 is provided with a plurality of conductor lines 51, 52. The conductor lines 51, 52 correspond to each of the bus bars 40, 40a. The conductor lines 51 respectively extend parallel to the Y-direction between the attachment portions 42, 46 in the bus bars 40, 40a and the PTC elements 60 arranged in the vicinity of the bus bars 40, 40a, and the conductor lines 52 respectively extend parallel to the X-direction between the PTC elements 60 and one end of the FPC board 50.

One end of each of the conductor lines 51 is exposed at a lower surface of the FPC board 50. The one ends of the conductor lines 51 exposed at the lower surface are respectively connected to the attachment portions 42, 46 in the bus bars 40, 40a by soldering or welding, for example. Thus, the FPC board 50 is fixed to the bus bars 40, 40a.

The other end of each of the conductor lines 51 and one end of each of the conductor lines 52 are exposed at an upper surface of the FPC board 50. A pair of terminals (not illustrated) of the PTC element 60 is connected to the other end of each of the conductor lines 51 and one end of each of the conductor lines 52 by soldering, for example.

Each of the PTC elements 60 can be arranged in a region between both ends in the X-direction of the corresponding bus bar 40, 40a. When stress is applied to the FPC board 50, a region of the FPC board 50 between the adjacent bus bars 40, 40a is easily deflected, while a region of the FPC board 50 between both the ends of each of the bus bars 40, 40a is kept relatively flat because it is fixed to the bus bar 40, 40a. Therefore, each of the PTC elements 60 is arranged within the region of the FPC board 50 between both the ends of each of the bus bars 40, 40a so that connection characteristics between the PTC element 60 and the conductor lines 51, 52 are sufficiently ensured. The effect of the deflection of the FPC board 50 on each of the PTC elements 60 (e.g., a change in the resistance value of the PTC element 60) is suppressed.

A plurality of connection terminals 22 corresponding to each of the conductor lines 52 in the FPC board 50 is provided in the printed circuit board 21. The other end of each of the conductor lines 52 in the FPC board 50 is connected to the corresponding connection terminal 22. The plurality of connection terminals 22 is electrically connected to the detecting circuit 20.

Each of the bus bars 40, 40a is thus electrically connected to the detecting circuit 20 via the corresponding PTC element 60.

### (5) Effects of Embodiment

When a short occurs between each of the bus bars 40, 40a and the detecting circuit 20 or within the detecting circuit 20, a large current is generated in a short-circuited portion from the corresponding bus bar 40, 40a. When such situations in which the large current flows are continued, the battery module 100 may deteriorate by generated heat.

In the present embodiment, the PTC element 60 is connected between each of the bus bars 40, 40a and the detecting circuit 20. The PTC element 60 has such resistance temperature characteristics as to have a resistance value logarithmically increasing when its temperature exceeds a certain value.

When a short occurs between the PTC element 60 and the detecting circuit 20 or within the detecting circuit 20, a large current flows through the PTC element 60. In the case, the temperature of the PTC element 60 rises by self-heating. This causes the resistance value of the PTC element 60 to increase, to inhibit the current flowing through the PTC element 60. Therefore, when a short occurs, situations in which the large current flows are quickly solved, to prevent the battery module 100 from deteriorating.

The PTC element 60 is arranged in the vicinity of each of the bus bars 40, 40a. Therefore, a short is very unlikely to occur due to disconnection between the PTC element 60 and each of the bus bars 40, 40a, for example.

Each of the conductor lines 52 may separate from the connection terminal 22 of the printed circuit board 21 and contact the other area so that a short occurs. In this case, situations in which a large current flows are also quickly solved by the increasing resistance value of the PTC element 60 connected between the conductor lines 51 and 52.

In the present embodiment, each of the bus bars 40, 40a and the printed circuit board 21 are electrically connected to each other by the conductor lines 51, 52 formed on the FPC board 50. In this case, the FPC board 50 has bending characteristics and flexibility. Even if external stress is applied to the FPC board 50 by vibration or the like, the FPC board 50 is not easily damaged. Thus, the conductor lines 51, 52 are not easily disconnected. Therefore, a short is prevented from occurring between each of the bus bars 40, 40a and the printed circuit board 21 better than when each of the bus bars 40, 40a and the printed circuit board 21 are connected to each other by a lead wire.

In the present embodiment, the PTC element 60 is connected between a folded portion of the FPC board 50 and each of the bus bars 40, 40a. Even if a short occurs in the folded portion of the FPC board 50, therefore, situations in which a large current flows are quickly solved by the increasing resistance value of the PTC element 60.

Each of the PTC elements 60 is arranged on the FPC board 50 so that the number of components on the printed circuit board 21 is reduced. This enables the printed circuit board 21 to be miniaturized. This further enables another circuit or another element to be provided on the printed circuit board 21.

When the volume of the battery cell 10 changes with charge/discharge or deterioration of the battery cell 10, the distance between the adjacent bus bars 40, 40a changes. Even in the case, the FPC board 50 is flexibly deflected, to prevent damage to the FPC board 50 and disconnection of the conductor lines 51, 52.

The bus bar 40, 40a may be respectively fixed to the electrodes 10a, 10b of the battery cells 10 with the FPC board 50 previously deflected between the adjacent bus bars 40, 40a. In the case, even if the distance between the adjacent bus bars 40, 40a increases by the increasing volume of each of the battery cells 10, the stress applied to the FPC board 50 can be relieved. This can more reliably prevent damage to the FPC board 50 and disconnection of the conductor lines 51, 52.

The PTC element 60 is arranged in the vicinity of each of the battery cells 10. When the temperature of the battery cell 10 rises, the temperature of the PTC element 60 also rises. Thus, the resistance value of the PTC element 60 increases, resulting in a produced voltage drop. A voltage applied to the detecting circuit 20 decreases by the voltage drop. Therefore, the detecting circuit 20 can detect abnormal heat generated by the battery cell 10 by detecting a change in the voltage without providing another temperature detector.

More specifically, when a terminal voltage of each of the battery cells 10 is kept constant, a voltage detected by the detecting circuit 20 decreases. When each of the battery cells 10 is charged/discharged, a voltage detected by the detecting circuit 20 irregularly decreases. Abnormal heat generated by the battery cell 10 can be detected based on such voltage changes.

The PTC element 60 is arranged to correspond to each of the battery cells 10. Therefore, the battery cell 10 that generates abnormal heat can be specified by detecting the voltage drop produced by the PTC element 60.

When the detecting circuit 20 detects the abnormal heat generated by the battery cell 10, the battery ECU 101 turns the contactor 102 off, for example. This prevents the battery module 100 from generating abnormal heat.

### (6) Modified Examples

### (6-1) Fixing of FPC Board and Bus Bar

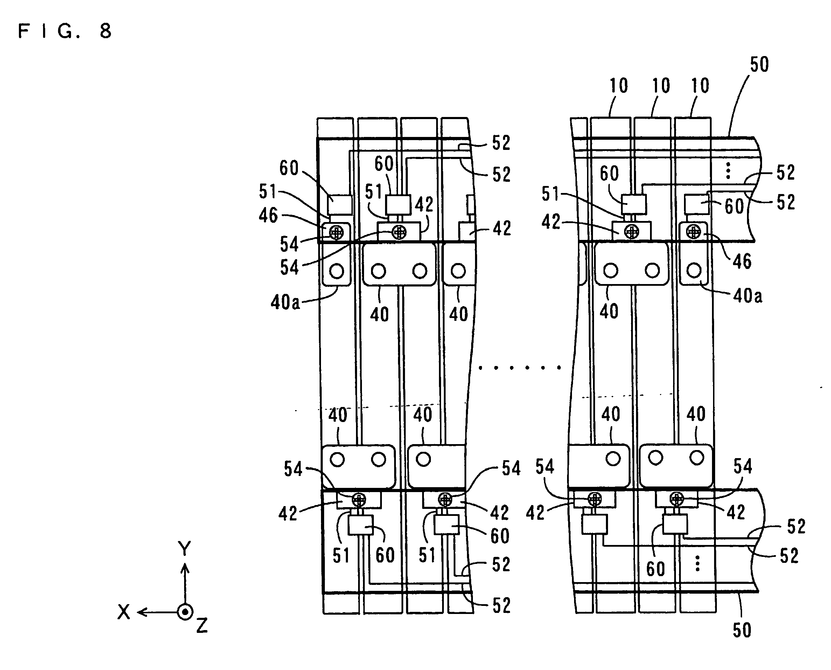

Fig. 8 is a schematic plan view and a schematic side view illustrating another example of a method for fixing an FPC board 50 and each of bus bars 40, 40a. The example illustrated in Fig. 8 differs from the example illustrated in Fig. 7 in the following points.

In the example illustrated in Fig. 8, each of the bus bars 40 is provided with an integral attachment portion 42 having a rectangular shape. The. FPC board 50 is attached to attachment portions 42, 46 in the bus bars 40, 40a, respectively, by screws 54. In this case, the FPC board 50 is reliably prevented from coming off each of the bus bars 40, 40a.

### (6-2) Arrangement of PTC Element

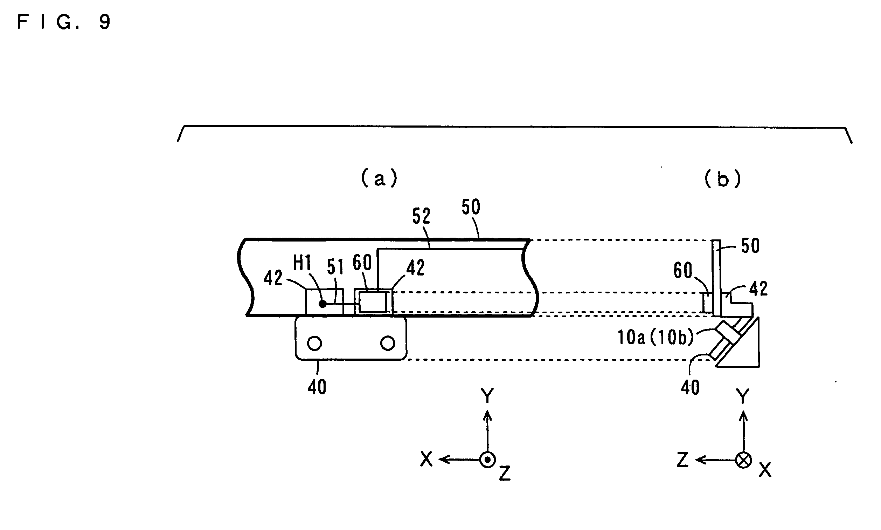

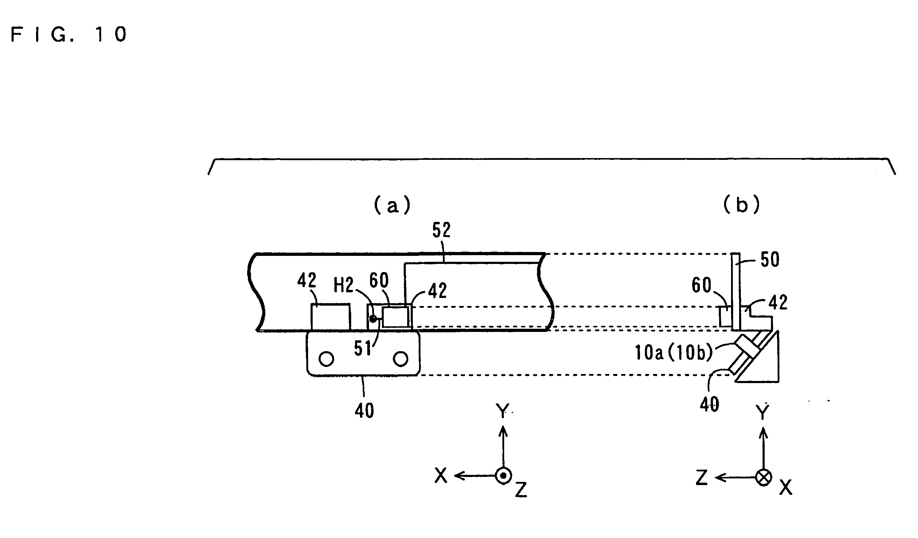

Figs. 9 (a) and 9 (b) are respectively a schematic plan view and a schematic side view illustrating another example of the arrangement of a PTC element 60. Figs. 10 (a) and 10 (b) are respectively a schematic plan view and a schematic side view illustrating still another example of the arrangement of a PTC element 60. The examples illustrated in Figs. 9 and 10 differ from the example illustrated in Fig. 7 in the following points.

In the example illustrated in Figs. 9 (a) and 9 (b), the PTC element 60 is attached to a portion of an FPC board 50 on one of attachment portions 42 in each of bus bars 40. A through hole H1 is formed in a portion of the FPC board 50 on the other attachment portion 42 in the bus bar 40. One end of each of conductor lines 51 are respectively connected to the other attachment portion 42 in the bus bar 40 via the through hole H1 and the other end of each of conductor lines 51 are respectively connected to one terminal of the PTC element 60 on the one attachment portion 42 in the bus bar 40.

In the example illustrated in Figs. 10 (a) and 10 (b), the PTC element 60 is attached to a portion of an FPC board 50 on one of attachment portions 42 in each of bus bars 40. A through hole H2 is formed in a portion of the FPC board 50 on the one attachment portion 42 in the bus bar 40. One end of each of conductor lines 51 are respectively connected to the one attachment portion 42 in the bus bar 40 via the through hole H2 and the other end of each of conductor lines 51 are respectively connected to one terminal of the PTC element 60 on the one attachment portion 42 in the bus bar 40.

During assembling, the PTC element 60 may be attached to the FPC board 50 after the bus bars 40, 40a are attached to the FPC board 50. In the case, if the FPC board 50 is deflected when the PTC element 60 is attached, the PTC element 60 is difficult to accurately position on the conductor lines 51, 52.

In the examples illustrated in Figs. 9 and 10, the PTC element 60 is attached to a portion, supported by the attachment portion 42 in the bus bar 40, of the FPC board 50. Since the portion, on which the PTC element 60 is attached, of the FPC board, 50 is not deflected, therefore, the PTC element 60 can be easily and accurately connected to the conductor lines 51, 52.

In the bus bar 40a illustrated in Fig. 5 (b), the PTC element 60 may be similarly attached to a portion, on the attachment portion 46 in the bus bar 40a, of the FPC board 50. In the case, a through hole is formed in the portion on the attachment portion 46 of the FPC board 50. One end of the conductor line 51 is connected to the attachment portion 46 in the bus bar 40a via the through hole.

### (6-3) Shape of FPC board

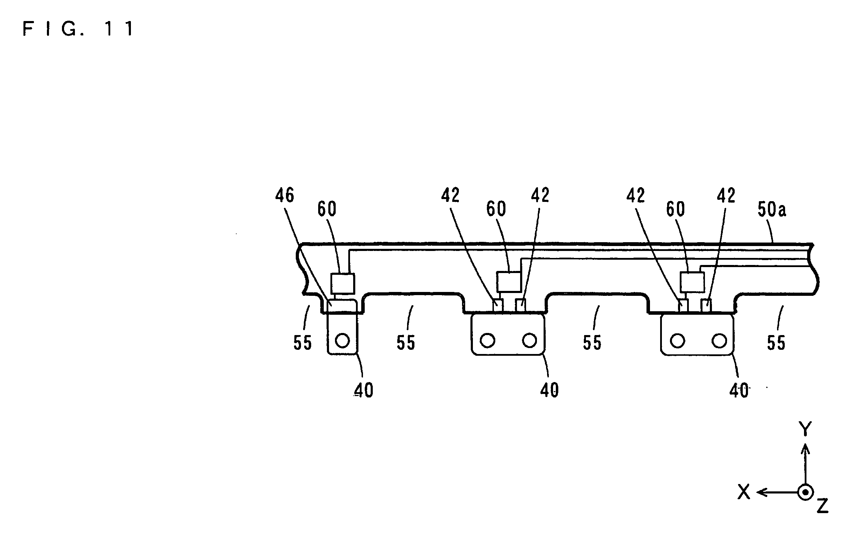

Fig. 11 is a schematic plan view illustrating a modified example of the FPC board 50. An FPC board 50a illustrated in Fig. 11 differs from the FPC board 50 illustrated in Fig. 7 in the following points.

The FPC board 50a has a notch 55 extending in the X-direction between portions respectively fixed to attachment portions 42, 46 in bus bars 40, 40a. An edge of the notch 55 can be positioned inside tip of the attachment portions 42, 46 in the bus bars 40, 40a in the Y-direction.

In this case, a region of the FPC board 50a between the adjacent bus bars 40, 40a can be flexibly deflected. Even if external stress is applied to the FPC board 50a, therefore, damage to the FPC board 50a and disconnection of conductor lines 51, 52 are more reliably prevented. Even if a position, on which each of the bus bars 40, 40a is attached, of a battery cell 10 is shifted due to a manufacturing error or the like, the FPC board 50a can be stably fixed to the bus bar 40, 40a by being flexibly deflected.

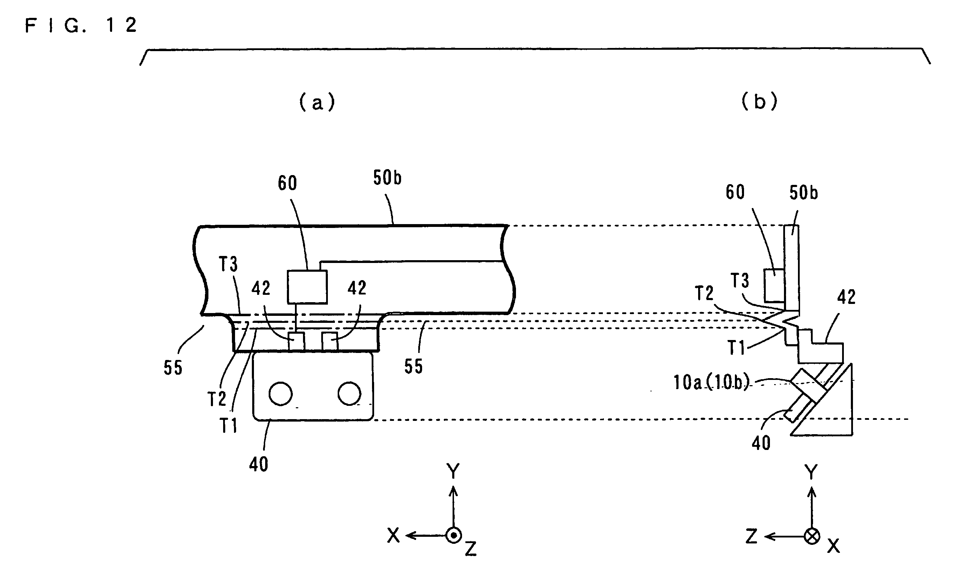

Figs. 12 (a) and 12 (b) are respectively a schematic plan view and a schematic side view illustrating a further modified example of the FPC board 50a. An FPC board 50b illustrated in Fig. 12 differs from the FPC board 50a illustrated in Fig. 11 in the following points.

Three bent portions T1, T2, T3 along the X-direction are formed in a convex-shaped region between notches 55 of the FPC board 50b. The bent portions T1, T2, T3 are provided between attachment portions 42, 46 in a bus bar 40, 40a and a PTC element 60. The FPC board 50b is mountain-folded in the bent portion T2, while being valley-folded in the bent portions T1, T3. The bent portion T3 can be provided on an extension of an edge of the notch 55.

In this case, even if a position, on which each of the bus bars 40, 40a is attached, of a battery cell 10 is shifted due to a manufacturing error or the like, distortion occurring in the FPC board 50b is further relieved in the bent portion T1. T2, T3. This enables the FPC board 50a to be stably fixed to each of the bus bars 40, 40a.

### (6-4) Shape of Electrode Connection Hole in Bus Bar

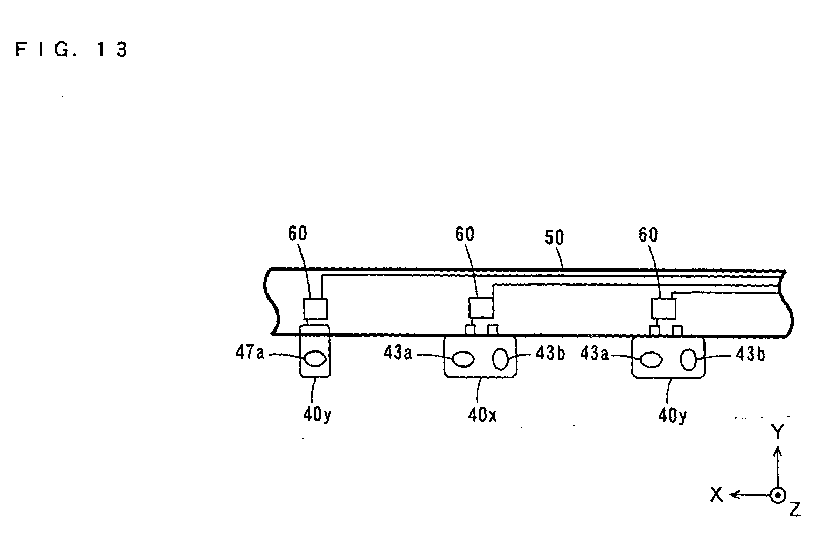

Fig. 13 is a schematic plan view illustrating a modified example of the bus bars 40, 40a. Bus bars 40x, 40y illustrated in Fig. 13 differ from the bus bars 40, 40a in the above-mentioned examples in the following points.

In the bus bar 40x for two electrodes, an elliptical electrode connection hole 43a extending in the X-direction and an elliptical electrode connection hole 43b extending in the Y-direction are formed in place of the pair of circular electrode connection holes 43. In the bus bar 40y for a single electrode, an elliptical electrode connection hole 47a extending in the X-direction is formed in place of the circular electrode connection hole 47.

In this case, the bus bars 40x, 40y can be shifted in the X-direction and the Y-direction with a plus electrode 10a or a minus electrode 10b of each of battery cells 10 (Fig. 3) inserted into the electrode connection holes 43a, 43b in the bus bar 40x, 40y. Even if the position of the plus electrode 10a or the minus electrode 10b of each of the battery cells 10 is shifted due to a manufacturing error, an increase/decrease in the volume of the battery cell 10, or the like, the positions of the bus bars 40x, 40y can be appropriately adjusted. This enables distortion occurring in an FPC board 50 to be relieved.

The shapes of the electrode connection holes 43a, 43b, 47a in the bus bars 40x, 40y may be changed, as needed. For example, the electrode connection holes 43a, 47a may be in an elliptical shape extending in the Y-direction. Alternatively, the electrode connection hole 43b may be in an elliptical shape extending in the X-direction. The electrode connection holes 43a, 43b, 47a may be in another shape such as a rectangular shape or a triangular shape.

The bus bars 40x, 40y may be attached to each of the above-mentioned FPC boards 50a, 50b. In the case, even if the position of the plus electrode 10a or the minus electrode 10b in each of the battery cells 10 (Fig. 3) is shifted, distortions occurring in the FPC board 50a, 50b can be relieved. Furthermore, even if distortion occurs in each of the FPC boards 50a, 50b, the FPC board 50a, 50b is stably fixed to the bus bars 40x, 40y by being flexibly deflected.

### (6-5) Another Modified Example

In the above-mentioned embodiment, each of the bus bars 40, 40a and the printed circuit board 21 are electrically connected to each other by the conductor lines 51, 52 formed on the FPC board 50. If a short between each of the bus bars 40, 40a and the printed circuit board 21 can be prevented, however, the bus bar 40, 40a and the printed circuit board 21 may be electrically connected to each other by another method.

For example, each of the bus bars 40, 40a and the printed circuit board 21 may be electrically connected to each other by a lead wire. The conductor lines 51, 52 may be formed on another flexible member such as clay or putty. The conductor lines 51, 52 may be formed on a rigid printed circuit board.

Each of the battery cells 10 and the printed circuit board 21 may be electrically connected to each other by directly connecting one end of the lead wire to the plus electrode 10a or the minus electrode 10b of the battery cell 10 and connecting the other end thereof to the printed circuit board 21.

Although in the above-mentioned embodiment, the battery cells 10 are connected in series, the present invention is not limited to the same. For example, parts or all of the battery cells 10 may be connected in parallel. Alternatively, the number of battery cells 10 connected in series may be set to obtain a required voltage, and the number of battery cells 10 connected in parallel may be set to obtain a required current.

The PTC element 60 may be used instead of a fuse for cutting off a current when the current has a value greater than a certain value. A self-recovering micro fuse (SRF) for automatically recovering an off state to an on state by a dielectrophoretic force of dielectric particles may be used as the fuse.

Although in the above-mentioned embodiment, the structures of the bus bars 40, 40a manufactured by forming a through hole in a metallic plate and subjecting the plate to bending or the like have been described (see Fig. 5), the bus bars 40, 40a need not necessarily be composed of a metallic plate.

For example, the bus bar 40 illustrated in Fig. 5 (a) may be used instead of a structure in which a pair of electrode connection holes 43 corresponding to the respective electrodes 10a, 10b of the battery cells 10 is formed in a metallic block having a substantially rectangular parallelepiped shape.

In this case, the plus electrode 10a and the minus electrode 10b of the adjacent battery cells 10 are fitted in the pair of electrode connection holes 43 formed in the bus bar 40. Each of the electrodes 10a, 10b is subjected to caulking in this state so that the bus bar 40 is attached to the battery cell 10. Note, the electrodes 10a, 10b may be welded to each of the bus bars 4.

The bus bar 40a illustrated in Fig. 5 (b) may be used instead of a structure in which an electrode connection hole 47 corresponding to the plus electrode 10a or the minus electrode 10b of the battery cell 10 is formed in a metallic block having a cubic shape.

In this case, the plus electrode 10a or the minus electrode 10b of the battery cell 10 is fitted in the electrode connection hole 47 formed in the bus bar 40a. The plus electrode 10a or the minus electrode 10b is subjected to caulking in this state so that the bus bar 40a is attached to the battery cell 10. Note, each of the electrodes 10a, 10b may be welded to each of the bus bars 40a.

In the above-mentioned embodiment, the terminal voltage of each of the battery cells 10 in the battery module 100 is detected via the voltage detection lines 51, 52. If a nickel hydrogen battery, for example, is used as the battery cell 10, however, a terminal voltage of the battery module 100 may be detected via the conductor lines 51 52. In the case, there may be provided only the conductor lines 51, 52 and the PTC element 60, which corresponds to the bus bar 40a attached to each of the battery cells 10 (the first battery cell 10 and the eighteenth battery cell 10) arranged at both the ends of the battery module 10, of the plurality of conductor lines 51, 52 and the plurality of PTC elements 60. Voltage detection lines may be directly connected, respectively, to the minus electrode 10b of the first battery cell 10 and the plus electrode 10a of the eighteenth battery cell 10.

### [2] Second Embodiment ,

An electric vehicle according to a second embodiment will be described below. The electric vehicle according to the present embodiment includes the battery module 100 and the battery system 500 according to the first embodiment. An electric automobile will be described below as an example of the electric vehicle.

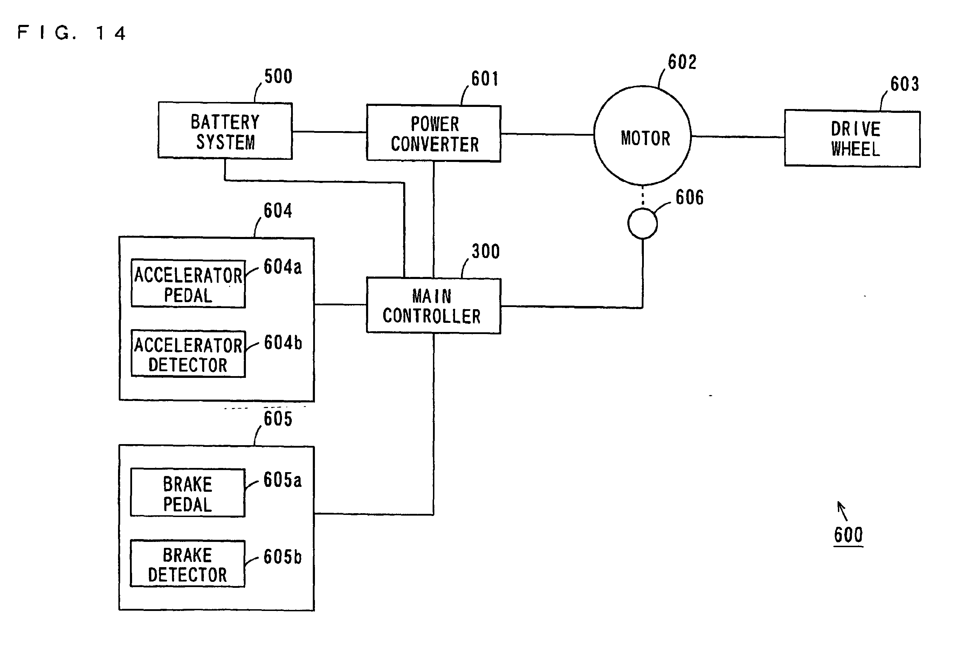

Fig. 14 is a block diagram illustrating the configuration of an electric automobile including the battery system 500 illustrated in Fig. 1. As illustrated in Fig. 14, an electric automobile 600 according to the present embodiment includes the main controller 300 and the battery system 500 illustrated in Fig. 1, a power converter 601, a motor 602, a drive wheel 603, an accelerator device 604, a brake device 605, and a rotational speed sensor 606. When the motor 602 is an alternating current (AC) motor, the power converter 601 includes an inverter circuit.

In the present embodiment, the battery system 500 is connected to the motor 602 via the power converter 601 while being connected to the main controller 300. As described above, the charged capacity of each of the plurality of battery modules 100 (Fig. 1) and the value of a current flowing through the battery module 100 are given to the main controller 300 from the battery ECU 101(Fig. 1) composing the battery system 500. The accelerator device 604, the brake device 605, and the rotational speed sensor 606 are connected to the main controller 300. The main controller 300 includes a CPU and a memory, or a microcomputer, for example.

The accelerator device 604 includes an accelerator pedal 604a and an accelerator detector 604b for detecting an operation amount (depression amount) of the accelerator pedal 604a, which are included in the electric automobile 600. When a driver operates the accelerator pedal 604a, the accelerator detector 604b detects the operation amount of the accelerator pedal 604a on the basis of a state where the accelerator pedal is not operated by the driver. The detected operation amount of the accelerator pedal 604a is given to the main controller 300.

The brake device 605 includes a brake pedal 605a and a brake detector 605b for detecting an operation amount (depression amount) of the brake pedal 605a by the driver, which are Included in the electric automobile 600. When the driver operates the brake pedal 605a, the brake detector 605b detects the operation amount. The detected operation amount of the brake pedal 605a is given to the main controller 300.

The rotational speed sensor 606 detects the rotational speed of the motor 602. The detected rotational speed is given to the main controller 300.

As described above, the charged capacity of the battery module 100, the value of the current flowing through the battery module 100, the operation amount of the accelerator pedal 604a, the operation amount of the brake pedal 605a, and the rotational speed of the motor 602 are given to the main controller 300. The main controller 300 carries out charge/discharge control of the battery module 100 and power conversion control of the power converter 601 based on the information.

When the electric automobile 600 is started and accelerated based on an accelerator operation, for example, the electric power of the battery module 100 is supplied to the power converter 601 from the battery system 500.

Furthermore, the main controller 300 calculates a torque (instruction torque) to be transmitted to the drive wheel 603 based on the given operation amount of the accelerator pedal 604a, and feeds a control signal based on the instruction torque to the power converter 601.

The power converter 601 that has received the control signal converts the electric power supplied from the battery system 500 into electric power (driving power) required to drive the drive wheel 603. Thus, the driving power obtained by the power converter 601 is supplied to the motor 602, and a torque generated by the motor 602 based on the driving power is transmitted to the drive wheel 603.

On the other hand, when the electric automobile 600 is decelerated based on a braking operation, the motor 602 functions as a power generation device. In this case, the power converter 601 converts regenerated electric power generated by the motor 602 into electric power suited to charge the battery module 100, and applies the electric power to the battery module 100. Thus, the battery module 100 is charged.

### [3] Correspondences between constituent elements in the claims and parts in embodiments

In the following two paragraphs, non-limiting examples of correspondences between various elements recited in the claims below and those described above with respect to various embodiments of the present invention are explained.

In the embodiments described above, the PTC element 60 or the fuse is an example of a current limiting element, the bus bars 40, 40a, 40x, 40y are examples of a connecting member, the conductors 51, 52 are examples of a voltage detection line, the X-direction is an example of one direction, the contactor 102 is an example of a connection switcher, the battery ECU 101 is an example of a controller, and the electric automobile 600 is an example of an electric vehicle.

As each of various elements recited in the claims, various other elements having configurations or functions described in the claims can also be used.

While embodiments of the present invention have been described above, it is to be understood that variations and modifications will be apparent to those skilled in the art without departing the scope of the present invention. The scope of the present invention, therefore, is to be determined solely by the following claims, as interpreted using the description and drawings.

## Claims

1. A battery module comprising:
a battery cell;
a voltage detection line connected to said battery cell for detecting a terminal voltage of said battery cell; and
a current limiting element inserted in said voltage detection line for limiting, when a current flowing through said voltage detection line is greater than a predetermined value, the current.

2. The battery module according to claim 1, wherein said battery cell is provided in plural numbers, further comprising
a connecting member for connecting electrodes of the adjacent battery cells to each other,
wherein said voltage detection line is provided in a flexible member attached to said connecting member and is connected to said connecting member.

3. The battery module according to claim 2, wherein
said flexible member is a flexible printed circuit board having said voltage detection line as a wiring pattern, and
said current limiting element is attached to said flexible printed circuit board.

4. The battery module according to claim 3, wherein
said flexible printed circuit board is attached to said connecting member to extend in one direction along said connecting member, and
said current limiting element is arranged in a region corresponding to a range between both ends of said connecting member in said one direction in said flexible printed circuit board.

5. A battery system for supplying electric power to a load, comprising:
a battery module;
a connection switcher configured to enable connection and disconnection between said battery module and said load; and
a controller that controls said connection switcher,
wherein said battery module further includes
a battery cell,
a voltage detection line connected to said battery cell for detecting a terminal voltage of said battery cell, and
a current limiting element inserted in said voltage detection line for limiting, when a current flowing through said voltage detection line is greater than a predetermined value, the current, and
said controller controls said connection switcher based on a voltage detected using the voltage detection line in said battery module.

6. An electric vehicle comprising:
a battery module;
a motor driven by electric power from said battery module; and
a drive wheel that rotates by a torque generated by said motor,
wherein said battery module further includes
a battery cell,
a voltage detection line connected to said battery cell for detecting a terminal voltage of said battery cell, and
a current limiting element inserted in said voltage detection line for limiting, when a current flowing through said voltage detection line is greater than a predetermined value, the current.
